Europäisches Patentamt

European Patent Office

Office européen des brevets

(19)

(11) Veröffentlichungsnummer: **0 158 035**
**B1**

(12) **EUROPÄISCHE PATENTSCHRIFT**

(45) Veröffentlichungstag der Patentschrift: **23.01.91**

(21) Anmeldenummer: **85101468.8**

(22) Anmeldetag: **12.02.85**

(51) Int. Cl.⁵: **H 03 M 5/14,** H 04 L 25/49,
G 11 B 20/14

(54) Schaltungsanordnung zur Bildung der laufenden digitalen Summe für ein digitales Datensignal.

(30) Priorität: **09.03.84 DE 3408646**

(43) Veröffentlichungstag der Anmeldung:
**16.10.85 Patentblatt 85/42**

(45) Bekanntmachung des Hinweises auf die
Patenterteilung:
**23.01.91 Patentblatt 91/04**

(84) Benannte Vertragsstaaten:
**DE FR GB IT**

(56) Entgegenhaltungen:
FR-A-2 469 047
US-A-3 810 111

FREQUENZ, Band 34, Nr. 2, Februar 1980, Seiten
45-52, Berlin, DE; R. DRULLMANN et al.:
"Leitungscodierung und betriebliche
Überwachung bei regenerativen Lichtleitkabel-
Übertragungssystemen"

(73) Patentinhaber: **ANT Nachrichtentechnik GmbH**
**Gerberstrasse 33**
**D-7150 Backnang (DE)**

(72) Erfinder: **Annecke, Karl-Heinz, Dr.**
**Nansenstrasse 25/2**
**D-7150 Backnang (DE)**
Erfinder: **Stallann, Jürgen**
**Sechselberger Weg 6**
**D-7150 Backnang (DE)**
Erfinder: **Bredemeier-Klonki, Volker**
**Königsberger Strasse 36**
**D-7155 Oppenweiler (DE)**

(56) Entgegenhaltungen:
**IBM JOURNAL OF RESEARCH AND**
**DEVELOPMENT, Band 27, Nr. 5, September**
**1983, Seiten 440-451, Armonk, New York, US;**
**A.X. WIDMER et al.: "A DC-balanced,**
**partitioned-block, 8B/10B transmission code"**

**IBM TECHNICAL DISCLOSURE BULLETIN, Band**
**24, Nr. 7A, Dezember 1981, Seiten 3156-3161,**
**New York, US; J.A. ROONEY: "DC limited (2, 7)**
**code and implementation"**

EP 0 158 035 B1

# EP 0 158 035 B1

**Beschreibung**

Die Erfindung betrifft eine Schaltungsanordnung zum Bilden und Überwachen der laufenden digitalen Summe für ein digitales Datensignal gemäß Oberbegriff des Patentanspruchs 1.

Solche Schaltungsanordnungen sind bekannt. Sie werden bei bestimten Übertragungscodes zur Überwchung und Erkennung von Fehlern benutzt. Beispielsweise werden bei einer Umsetzung von 5-Bit-codierten auf 6-Bit-codierten Datenwörtern bei einer fehlerfreien Übertragung bestimmte Summationsgrenzen $\pm G$ der laufenden digitalen Summe (LDS) nicht überschritten. Wird die Summatoinsgrenze überschritten, so erfolgt eine Anzeige, welche aussagt, daß Übertragungsfehler erfolgt sind. Die Anzahl der Fehler und die Fehlerposition im Datenstrom sind unbekannt. Aufgrund des Überlaufs der LDS wird eine Fehlerkorrektur, beispielsweise durch Wiederholung, in die Wege geleitet.

Das Grundelement herkömmlicher LDS-Schaltungen ist ein Schieberegister. In diesem Schieberegister wird ein Zeiger zur Schieberegisterfunktion "Rechtsshift" oder "Linksshift" entsprechend des Wertes der übertragenen Datenbits zwischen den Summationsgrenzen $+G$ und $-G$ verschoben. Zur Realisierung der hermömmlichen LDS-Schaltungen, wie beispielsweise in den integrierten Schaltkreisen SP 1450 B (B) und SP 1455 B (B) von Plessey, wird ein Schieberegister der Länge 2x Betrag $G + 1$ Bit benötigt, sowie eine Ansteuerungslogik für die Schiebefunktion des Registers und eine Anordnung zur Anzeige des Überlaufs der Summationsgrenzen.

Durch den Aufsatz "Leitungskodierung und betriebliche Überwachung bei regenerativen Lichtleitkabel-Übertragungssystemen" von Drullmann und Kammerer, Frequenz, Band 34, Februar 1980, Seite 45ff, ist eine Schaltungsanordnung zum Ermitteln der laufenden digitalen Summe eines 5B6B-codierten Datensignals bekannt geworden, wobei folgende Elemente verwendet werden:

ein erstes Flip-Flop zum Zwischenspeichern des Datensignals,

drei weitere Flip-Flops, die mit einer logischen Verknüpfungsschaltung einen synchronen Auf-/Abwärtszähler bilden, wobei das Ausgangssignal durch logische Verknüpfung der vier Flip-Flops gebildet wird und anzeigt, ob die LDS einen vorgegebenen Grenzwert $+3$, $-3$ überschreitet.

Nachteil der herkömmlichen LDS-Schaltungen ist, daß viele Bauelemente benötigt werden, die eine entsprechend hohe Verlustleistung zur Folge haben. Der Einsatz für hohe Bitraten erscheint deshalb fast aussichtslos.

Der vorliegenden Erfindung lag die Aufgabe zugrunde, eine Schaltungsanordnung der eingangs genannten Art anzugeben, welche einen wesentlich kleineren Schaltungsaufwand erfordert und welche für die Übertragung mit hohen Bitraten geeignet ist.

Die Lösung erfolgt mit den im Hauptanspruch angegebenen gekennzeichneten Merkmalen. Eine Ausbildung findet sich im Unteranspruch.

Die erfindungsgemäße Schaltungsanordnung weist die Vorteile auf, daß sie nur eine geringe Anzahl von Bauelementen benötigt und somit eine entsprechend geringe Verlustleistng hat. Die Anordnung ist daher prädestiniert für eine Schaltungsintegration, und ihr Einsatz ist für hohe Bitraten, beispielsweise für 565-Mbit/s-Übertragungen, möglich.

Die Erfindung geht aus von de Idee, daß das Verschieben eines Zeigers in einem Schieberegister in Abhängigkeit von dem Wert der übertagenen Datenbits auch als eine Art von Zählen interpretiert werden kann. Dbei wird jede Wertänderung der Datenbits durch eine Zählrichtungsänderung angezeigt. Erreicht der Zähler die festgesetzten Summationsgrenzen $+G$ oder $-G$, so wird der erreichte Zählerstand bis zur nächsen Wertänderung der Datenbits gehalten. Der Zähler wird bei der vorliegenden Schaltungsanordnung durch eine Binärzähleranordnung realisiert.

Es folgt nun die Beschreibung der Erfindung anhand der Figuren:

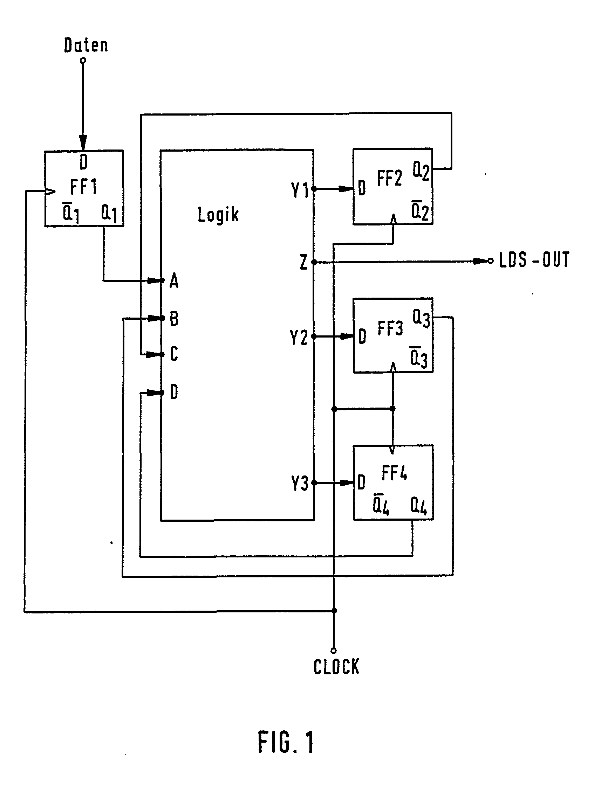

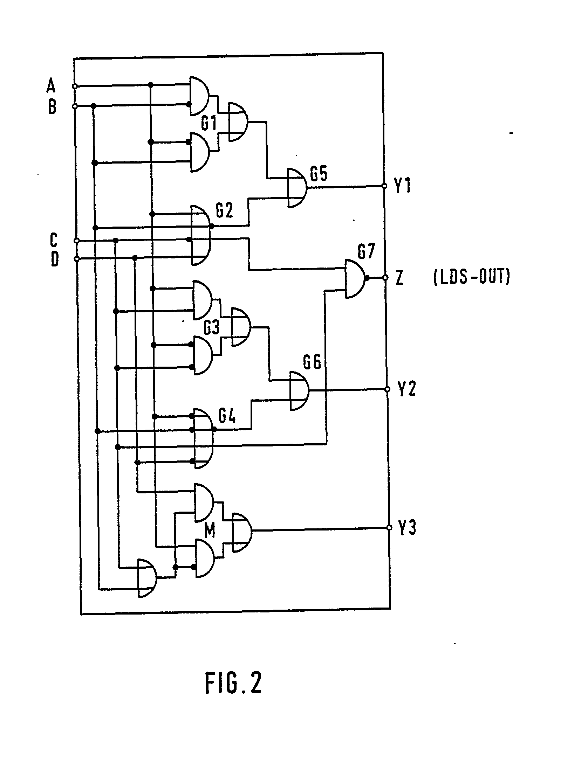

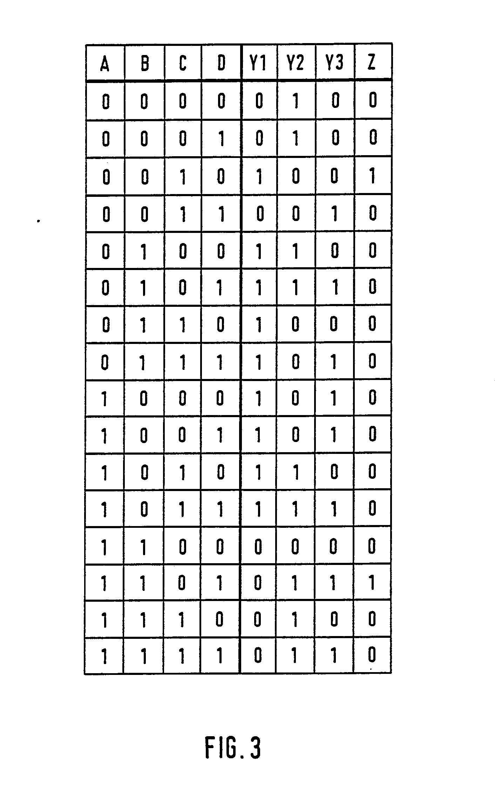

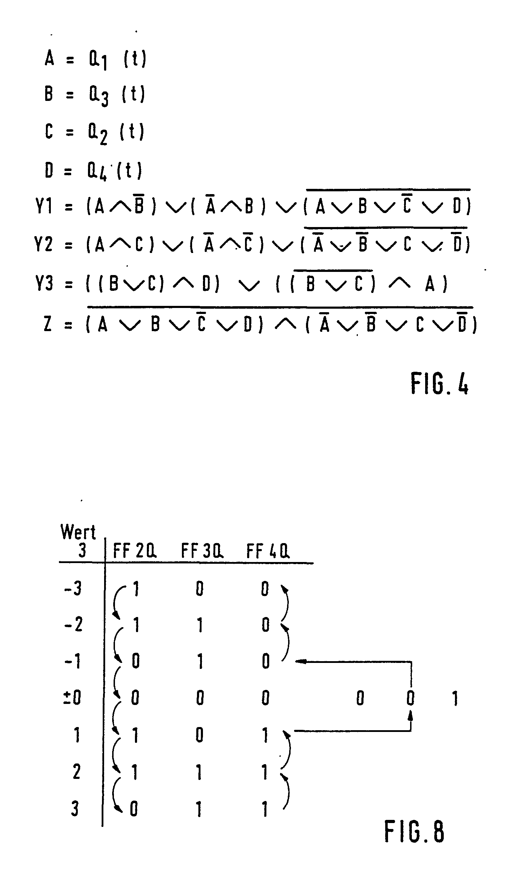

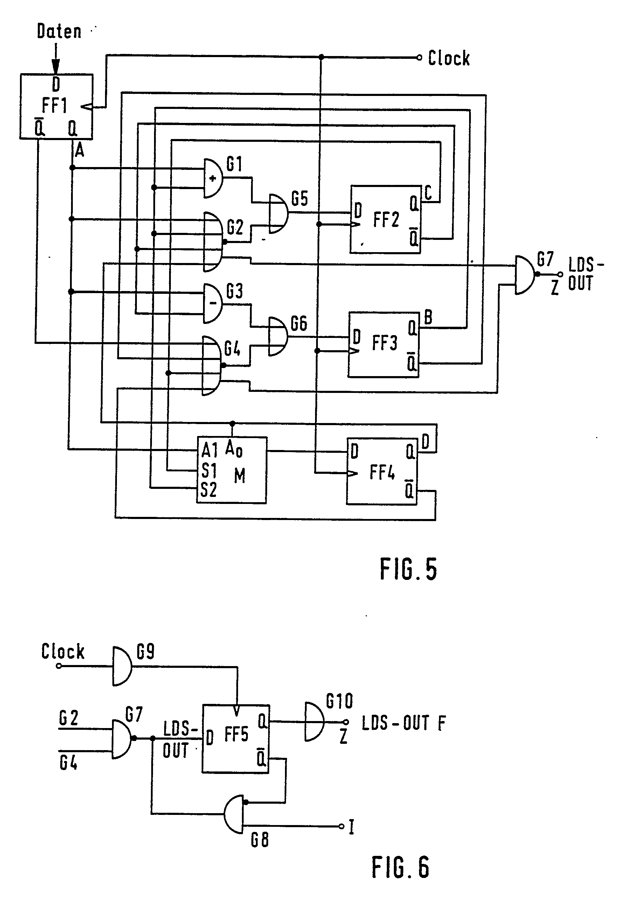

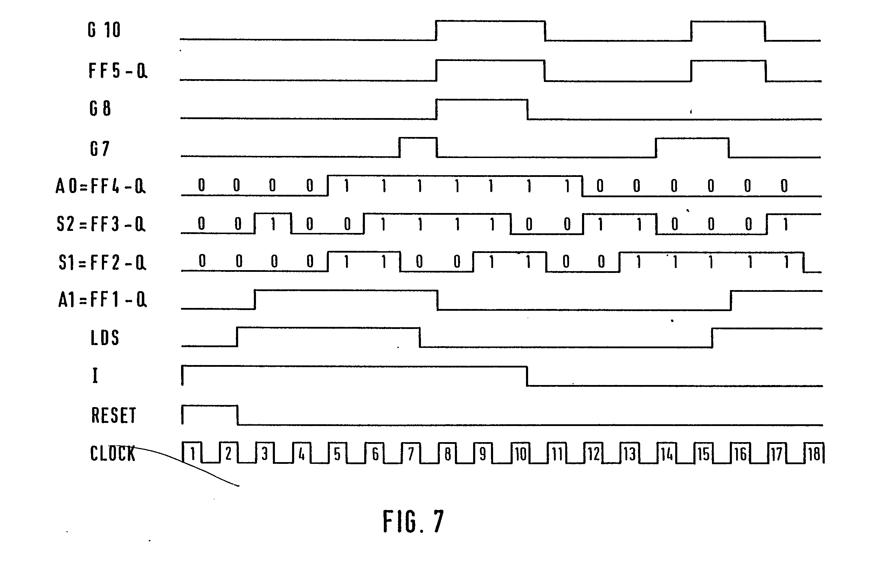

Figur 1 zeigt ein Blockschaltbild für einen Auf-/Abwärtszähler mit den Grenzen $\pm 3$. In Figur 2 ist eine Schaltungsrealisierung der Logik nach Figur 1 gemäß der Wahrheitstabelle nach Figur 3 bzw. den logischen Gleichungen nach Figur 4 gezeichnet. In Figur 5 ist die erfindungsgemäße Realisierung für eine LDS-Zähler mit nur wenigen Gattern und einem Multiplexer dargestellt. Die Figur 6 zeigt eine Schaltungseinzelheit für das Fangen einer Grenzüberschreitung. In Figur 7 ist ein Implsdiagramm dargestellt für die Realisierung nach Figur 5 zusammen mit Figur 6. In Figur 8 schließlich ist eine Tabelle aufgelistet, welche die Wertzuweisung auf die Zustände der drei D-Flip-Flops 2, 3 und 4 des Auf-/Abwärtszählers zeigt.

Das Blockschaltbild nach Figur 1 zeigt ein Eingangsdaten-Flip-Flop FF1, in dessen Eingang die Daten einlaufen. Ferner sind drei weitere D-Flip-Flops FF2, FF3 und FF4 gezeichnet sowie eine logische Verknüpfungsschaltung Logik mit dem den Eingängen a, B, D und D und den Ausgängen Y1, Y2, Y3 und Z, welch letzterer das Ausgangssignal für die laufende digitale Summe LDS-OUT darstellt. Die Flip-Flops Werden durch den Takt CLOCK getaktet.

In Figur 2 ist eine Realisierung für die logische Verknüpfung Logik im einzelnen dargestellt durch logische Verknüpfungsglieder G1 bis G7 sowie durch einen Multiplexer M, wobei einzelne Verknüpfungsglieder wie G1, G3 und der Multiplexer M jeweils durch zwei UND-Glieder und ein ODER-Glied realisiert sind. Die Anordnung ist nach der Wahrheitstabelle der Figur 3 bzw. nach den logischen Verknüpfungsgleichungen der Figur 4 aufgebaut. Die Figur 5 zeigt den erfindungsgemäßen Auf-/Abwärtszähler, der außer dem Multiplexer M und den drei D-Flip-Flops FF2 bis FF4 lediglich sieben Gatter G1 bis G7 aufweist, wobei die Gatter G1 und G3 ausschließlich ODER-Schaltungen mit zwei Eingängen, die

2

Gatter G2 und G4 ODER-Schaltungen mit vier Eingängen, die Gatter G5 und G6 ODER-Schaltungen mit zwei Eingängen und das Gatter G7 ein UND-Glied sind. Die Eingänge der logischen Verknüpfungsglieder sind wie folgt beaufschlagt:

Ausschließendes ODER-Glied G1:

$Y1 = A$

$Y2 = B$

ODER-Glied G2:

$Y1 = A$

$Y2 = B$

$Y3 = \bar{C}$

$Y4 = D$

ausschließendes ODER-Glied G3:

$Y1 = A$

$Y2 = \bar{C}$

ODER-Glied G4:

$Y1 = \bar{A}$

$Y2 = \bar{B}$

$Y3 = C$

$Y4 = \bar{D}$

ODER-Glied G5:

$Y1 = G1$

$Y2 = \overline{G2}$

ODER-Glied G6:

$Y1 = G3$

$Y2 = \overline{G4}$

UND-Glied G7:

$Y1 = G2$

$Y2 = G4$

die Belegung des Multiplexers M ist wie folgt:

$A0 = D$

$A1 = A$

$S1 = C$

$S2 = B$

die Belegung des Flip-Flops FF2:

$Y = G5$

FF3:

$Y = G6$

FF4:

$Y = M$

das Ausgangssignal LDS-OUT:

$Z = \overline{G7}$

Zur Berechnung der laufenden digitalen Summe eines 5B- 6B-codierten Datenstroms wird eine LDS-Schaltung mit den Begrenzungen ±3 benötigt, wie sie in Figur 5 dargestellt ist. Die laufende digitale Summe wird in den im wesentlichen durch die Flip-Flops FF2, FF3 und FF4 repräsentierten Zähler aufgenommen, wobei den einzelnen Zählerständen jeweils ein gewisser Wert (Summe) zugewiesen wird, wie in Figur 8 dargestellt ist. Bei Erreichen der Summe +3 oder −3 hat ein weiteres zu übertragendes Datenbit, welches das gleich Vorzeichen wie das der erreichten Grenze aufweist, zur Folge, daß am Ausgang von G7 ein Impuls der Länge n X T ansteht. T ist dabei die Periodendauer des Taktes CLOCK, und n ist die Anzahl der Datenbits, die den Überlauf verursachen. Mit der Fangschaltung nach Figur 6 können die Umlaufimpulse mit I beliebig verlängert werden. Hierbei ist ein weiteres D-Flip-Flop-FF5 vorgesehen, dessen Eingang von LDS-OUT beaufschlagt ist. Sobald ein Überlauf erfolgt, wird das Flip-Flop FF5 gesetzt, wodurch über eine Konjunktionsschaltung G8 mit dem Verlängerungssignal I, welche Konjunktionsschaltung in einer Rückkoppelschleife auf den Eingang des Flip-Flops FF5 führt, der Eingang besetzt bleibt.

Der Takt für das Flip-Flop FF5 ist aus Gründen der Laufzeitanpassung über ein Gatter G9 geführt.

Die in Figur 5 realisierte Schaltungsanordnung weist gegenüber den herkömmlichen Lösungen, die mit einem Schieberegister arbeiten, eine minimale Anzahl von Verknüpfungsgliedern auf, was sich günstig auf

3

den Leistungsverbrauch auswirkt. Außerdem ist die Schaltungsstruktur derart, daß die Verknüpfungslogik lediglich zweiter Ordnung ist, so daß die Schaltungsanordnung bestens geeignet ist für hohe Datenübertragungsraten. Unter Ausnutzung der Möglichkeiten zur Überführung von ODER- oder UND-Gliedern in WIRED-OR bzw. WIRED-AND kann die Verknüpfungslogik bei der Realisierung in entsprechenden Technologien auf eine Struktur erster Ordnung reduziert werden, so daß die Laufzeit der Verknüpfungslogik zwischen den Flip-Flop-Ebenen noch weiter reduziert werden kann, wodurch eine weitere Erhöhung der Datenübertragungsrate ermöglicht wird.

**Patentansprüche**

1. Schaltungsanordnung zum Ermitteln und Überwachen der laufenden digitalen Summe aus einem digitalen Datensignal, wobei die einzelnen Datenbits mit den Werten +1 im Falle einer Binärziffer 1 und −1 im Falle einer Binärziffer 0 bewertet und aufsummiert werden und wobei eine Anzeige erfolgt, wenn die laufende digitale Summe (LDS) einen bestimmten vorgebbaren Betrag überschrietet, mit einem ersten D-Flip-Flop (FF1) zur Zwischenspeicherung des Dateneingangssignals, einem Auf-/Abwärtszähler aus drei weiteren D-Flip-Flops (FF2, FF3, FF4) und einer logischen Verknüpfungsschaltung (Logik), wobei die Ein-(Y1, Y2, Y3) und Ausgangssignale (C = Q2 (t), B = Q3 (t), D = Q4 (t)) der drei weiteren D-Flip-Flops (FF2, FF3, FF4) und das Ausgangssignal (A = Q1 (t)) des ersten D-Flip-Flops (FF1) mittels logischer Verknüpfungsglieder nach den Vorschriften

$$Y1 = (A \wedge \overline{B}) \vee (\overline{A} \wedge B) \vee \overline{(A \vee B \vee \overline{C} \vee D)} \qquad (1)$$

$$Y2 = (A \wedge C) \vee (\overline{A} \wedge \overline{C}) \vee \overline{(\overline{A} \vee \overline{B} \vee C \vee \overline{D})} \qquad (2)$$

$$Y3 = ((B \vee C) \wedge D) \vee ((B \vee \overline{C}) \wedge A) \qquad (3)$$

oder in äquivalenter Form verknüpft werden und wobei sich das Ausgangssignal (Z) des Auf-/Abwärtszählers aus der logischen Verknüpfung

$$Z = (A \vee B \vee \overline{C} \vee D) \wedge (\overline{A} \vee \overline{B} \vee C \vee \overline{D}) \qquad (4)$$

ergibt, dadurch gekennzeichnet, daß zwei ausschließende ODER-Glieder (G1, G3), zwei ODER-Glieder (G2, G4) mti vier Eingängen, zwei ODER-Glieder (G5, G6) mtik zwei Eingängen, ein UND-Glied (G7) und ein Zwei:Eins-Multiplexer (M) vorgesehen sind, und daß die Eingänge dieser Verknüpfungsglieder wie folgt beaufschlagt werden:

erstes ausschließendes ODER-Glied (G1):     $Y1 = A$

$Y2 = B$

zweites ausschließendes ODER-Glied (G3):     $Y1 = A$

$Y2 = \overline{C}$

erstes ODER-Glied mit vier Eingängen (G2):     $Y1 = A$

$Y2 = B$

$Y3 = \overline{C}$

$Y4 = D$

zweites ODER-Glied mit vier Eingängen (G4):     $Y1 = \overline{A}$

$Y2 = \overline{B}$

$Y3 = C$

$Y4 = \overline{D}$

erstes ODER-Glied mit zwei Eingängen (G5):      $Y1 = G1$

$Y2 = \overline{G2}$

zweites ODER-Glied mit zwei Eingängen (G6):     $Y1 = G3$

$Y2 = \overline{G4}$

UND-Glied (G7):     $Y1 = G2$

$Y2 = G4$

die Belegung des Multiplexers M ist wie folgt:     $A0 = D$

$A1 = A$

$S1 = C$

$S2 = B$

die drei weiteren D-Flip-Flops FF2:     $Y1 = G5$

FF3:     $Y1 = G6$

FF4:     $Y1 = M$

das Ausgangssignal Z:     $Z = \overline{G7}$,

wobei $G_1$, $G_2$, $\overline{G2}$, G3, G4, $\overline{G4}$, G5, G6, $\overline{G7}$, M die Ausgangssignale bzw. die invertierten Ausgangssignale der entsprechenden Glieder bzw. des Multiplexers und wobei Y1, Y2, Y3, Y4, A0, A1, S1, S2 die Eingangssignale dieser logischen Verknüpfungsglieder bzw. die Dateneingangssignale bzw. die Sezeingänge des Multiplexerts (M) sind.

2. Schaltungsanordnung nach Anspruch 1, dadurch gekennzeichnet, daß eine Fangschaltung vorgesehen ist, mittels der ein Überschreiten der laufenden digitalen Summe über den vorgebbaren Wert speicherbar it, indem das Ausgangssignal (Z) des Auf-/Abwärtzählers auf den Eingang eines weiteren D-Flip-Flops (FF5) geführt ist und wobei dessen Ausgangssignal (Q5 (t)) über ein weiteres UND-Glied (G8), dessen zweiter Eingang von einem das Fangen erlaubenden oder abschaltenden Signal (I) angesteuert ist, ebenfalls auf seinen Eingang zurückgeführt ist.

## Revendications

1. Dispositif électronique pour la détermination et la surveillance de la valeur numérique cumulée à partir d'un signal numérique de données, les bits de données individuels étant affectés de la valeur +1 dans le cas d'un chiffre binaire 1 et de la valeur −1 dans le cas d'un chiffre binaire 0, et étant comptabilisés de cette manière et une indication apparaissant lorsque la valeur numérique cumulée (LDS) dépasse un seuil déterminé fixé à l'avance, avec une première bascule D (FF1) pour constituer une mémoire intermédiate du signal d'entrée des données, un compteur-décompteur composé de trois autres bascules D (FF2, FF3, FF4) et un circuit logique combinatoire (Logik), les signaux d'entrée (Y1, Y2, Y3) et de sortie (C = Q2 (t), B = Q3 (t), D = Q4 (t)) concernant les trois autres bacules D (FF2, FF3, FF4) et le signal de sortie (A = Q1 (t)) de a première bascule (FF1) sont élaborés à l'aide d'opérateurs logiques en fonction des règles suivantes:

$$Y1 = (A \wedge \overline{B}) \vee (\overline{A} \wedge B) \vee \overline{(A \vee B \vee \overline{C} \vee D)} \qquad (1)$$

$$Y2 = (A \wedge C) \vee (\overline{A} \wedge \overline{C}) \vee \overline{(\overline{A} \vee \overline{B} \vee C \vee \overline{D})} \qquad (2)$$

$$Y3 = ((B \vee C) \wedge D) \vee ((B \vee \overline{C}) \wedge A) \qquad (3)$$

ou sous une forme équivalente, le signal de sortie (Z) du compteur-décompteur étant obtenu par l'enchaînement logique suivante:

$$Z = (A \vee B \vee \overline{C} \vee D) \wedge (\overline{A} \vee \overline{B} \vee C \vee \overline{D}) \qquad (4)$$

le dispositif étant caractérisé en ce qu'il comprend l'utilisation de deux portes "OU exclusif" (G1, G3), deux portes "OU" (G2, G4) à quatre entrées, deux portes "OU" (G5, G6) à deux entrées, unbe porte (ET" (G7) et un système de Multiplexage (M) deux:un, et en ce que ces différents opérateurs logiques reçoivent les informations d'entrée suvantes:

```
première porte "OU" exclusif" (G1)              Y1 = A
                                                Y2 = B

deuxième porte "OU exclusif" (G3)               Y1 = A
                                                Y2 = C̄

première porte "OU" à quatre entrées (G2)       Y1 = A
                                                Y2 = B
                                                Y3 = C̄
                                                Y4 = D

deuxième porte "OU" à quatre entrées (G4)       Y1 = Ā
                                                Y2 = B̄
                                                Y3 = C
                                                Y4 = D̄

première porte "OU" à deux entrées (G5)         Y1 = G1
                                                Y2 = G2̄

deuxième porte "OU" à deux entrées (G6)         Y1 = G3
                                                Y2 = G4̄

porte "ET" (G7)                                 Y1 = G2
                                                Y2 = G4

le branchement du Multiplexeur M est le suivant  A0 = D
                                                A1 = A
                                                S1 = C
                                                S2 = B

les trois autres bascules D FF2 :               Y1 = G5
                          FF3 :                  Y1 = G6
                          FF4 :                  Y1 = M
le signal de sortie Z :                         Z = G7̄
```

les coordonnées G1, G2, G2̄, G3, G4, G4̄, G5, G6, G7̄, et M représentant les signaux de sortie ou les signaux de sortie inversés des portes correspondantes ou du multiplexeur, et les coordonnées Y1, Y2, Y3, Y4, A0, A1, S1, S2, représentant les signaux d'entrée de ces opérateurs logiques, ou les signaux d'entrée de données ou les signaux d'entrée de positionnement du Multiplexeur (M).

2. Dispositif électronique selon la revendication 1, caractérisé en ce qu'il comprend un circuit de détection, à l'aide duquel peut être mémorisé un dépassement de la valeur numérique cumulée par rapport au seuil fixé à l'avance, le signal de sortie (Z) du compteur-décompteur étant appliqué à l'entrée d'une bascule D supplémentaire (FF5) dont le propre signal de sortie (Q5 (t)) est de la même manière ramené sur son entrée par l'intermédiaire d'un autre porte "ET", dont la deuxième entrée est commandée par un signal (I) qui permet d'autoriser ou d'interdire la détection.

**Claims**

1. Circuit arrangement for determining and monitoring the running digital sum of a digital data signal, wherein the individual data bits are assigned the value +1 in the case of a binary number 1 and the value −1 in the case of a binary number 0 and added up and wherein an indication takes place when the running digital sum (LDS) exceeds a certain predeterminable amount, with a first D-flip-flop (FF1) for the intermediate storage of the data input signal, a reversible counter of three further D-flip-flops (FF2, FF3, FF4) and a logic interlinking circuit (Logik), wherein the input signals (Y1, Y2, Y3) and the output signals $(C = Q2(t), B = Q3(t), D = Q4(t))$ of the three further D-flip-flops (FF2, FF3, FF4) and the output signal $(A = Q1(t))$ of the first D-flip-flop (FF1) are interlinked by means of logic interlinking members according to the rules

$$Y1 = (A \wedge \overline{B}) \vee (\overline{A} \wedge B) \vee \overline{(A \vee B \vee \overline{C} \vee D)} \qquad (1)$$

$$Y2 = (A \wedge C) \vee (\overline{A} \wedge \overline{C}) \vee \overline{(\overline{A} \vee \overline{B} \vee C \vee \overline{D})} \qquad (2)$$

$$Y3 = ((B \vee C) \wedge D) \vee ((B \vee \overline{C}) \wedge A) \qquad (3)$$

or in equivalent form and wherein the output signal (Z) of the reversible counter results from the logic interlinking

$$Z = (A \vee B \vee \overline{C} \vee D) \wedge (\overline{A} \vee \overline{B} \vee C \vee \overline{D}) \qquad (4)$$

characterised thereby, that two exclusive OR-members (G1, G3), two OR-members (G2, G4) with four inputs, two OR-members (G5, G6) with two inputs, and AND-member (G7) and a two:one multiplexer (M) are provided and that the inputs of these interlinking members are acted on as following:

| | |
|---|---|
| first exclusive OR-member (G1): | Y1 = A |
| | Y2 = B |
| second exclusive OR-member (G3): | Y1 = A |
| | Y2 = $\overline{C}$ |
| first OR-member with four inputs (G2): | Y1 = A |
| | Y2 = B |
| | Y3 = $\overline{C}$ |
| | Y4 = D |
| second OR-member with four inputs (G4): | Y1 = $\overline{A}$ |
| | Y2 = $\overline{B}$ |
| | Y3 = C |
| | Y4 = $\overline{D}$ |
| first OR-member with two inputs (G5): | Y1 = G1 |
| | Y2 = $\overline{G2}$ |
| second OR-member with two inputs (G6): | Y1 = G3 |
| | Y2 = $\overline{G4}$ |
| AND-member (G7): | Y1 = G2 |
| | Y2 = G4 |

EP 0 158 035 B1

the occupancy of the multiplexer M is as following:

A0 = D
A1 = A
S1 = C
S2 = B

the three further D-flip flops FF2:  Y1 = G5
FF3:  Y1 = G6
FF4:  Y1 = M
Z = $\overline{G7}$,

wherein G1, G2, $\overline{G2}$, G3, G4, $\overline{G4}$, G5, G6, $\overline{G7}$, and M are either the output signals or the inverted output signals of the corresponding member of the multiplexer and wherein Y1, Y2, Y3, Y4, A0, A1, S1 and S2 are either the input signals of these logic interlinking members or the data input signals or the setting inputs of the multiplexer (M).

2. Circuit arrangement according to claim 1 characterised thereby, that a catching circuit is provided, by means of which an exceeding of the running digital sum over the predeterminable value is storable in that the output signal (Z) of the reversible counter is led to the input of a further D-flip-flop (FF5) and wherein the output signal (Q5(t)) thereof is likewise led back to its input by way of a further AND-member (G8), the second input of which is driven by a signal (I) permitting or switching off the catching.

8

FIG. 1

FIG.2

EP 0 158 035 B1

| A | B | C | D | Y1 | Y2 | Y3 | Z |
|---|---|---|---|----|----|----|---|
| 0 | 0 | 0 | 0 | 0 | 1 | 0 | 0 |
| 0 | 0 | 0 | 1 | 0 | 1 | 0 | 0 |
| 0 | 0 | 1 | 0 | 1 | 0 | 0 | 1 |
| 0 | 0 | 1 | 1 | 0 | 0 | 1 | 0 |
| 0 | 1 | 0 | 0 | 1 | 1 | 0 | 0 |
| 0 | 1 | 0 | 1 | 1 | 1 | 1 | 0 |
| 0 | 1 | 1 | 0 | 1 | 0 | 0 | 0 |
| 0 | 1 | 1 | 1 | 1 | 0 | 1 | 0 |
| 1 | 0 | 0 | 0 | 1 | 0 | 1 | 0 |
| 1 | 0 | 0 | 1 | 1 | 0 | 1 | 0 |
| 1 | 0 | 1 | 0 | 1 | 1 | 0 | 0 |
| 1 | 0 | 1 | 1 | 1 | 1 | 1 | 0 |
| 1 | 1 | 0 | 0 | 0 | 0 | 0 | 0 |
| 1 | 1 | 0 | 1 | 0 | 1 | 1 | 1 |
| 1 | 1 | 1 | 0 | 0 | 1 | 0 | 0 |
| 1 | 1 | 1 | 1 | 0 | 1 | 1 | 0 |

FIG. 3

3

$$A = Q_1(t)$$

$$B = Q_3(t)$$

$$C = Q_2(t)$$

$$D = Q_4(t)$$

$$Y1 = (A \wedge \bar{B}) \vee (\bar{A} \wedge B) \vee \overline{(A \vee B \vee \bar{C} \vee D)}$$

$$Y2 = (A \wedge C) \vee (\bar{A} \wedge \bar{C}) \vee \overline{(\bar{A} \vee \bar{B} \vee C \vee \bar{D})}$$

$$Y3 = ((B \vee C) \wedge D) \vee (\overline{(B \vee C)} \wedge A)$$

$$Z = \overline{(A \vee B \vee \bar{C} \vee D) \wedge (\bar{A} \vee \bar{B} \vee C \vee \bar{D})}$$

FIG. 4

| Wert 3 | FF 2Q | FF 3Q | FF 4Q | | | |
|---|---|---|---|---|---|---|
| -3 | 1 | 0 | 0 | | | |
| -2 | 1 | 1 | 0 | | | |
| -1 | 0 | 1 | 0 | | | |
| ±0 | 0 | 0 | 0 | 0 | 0 | 1 |
| 1 | 1 | 0 | 1 | | | |
| 2 | 1 | 1 | 1 | | | |
| 3 | 0 | 1 | 1 | | | |

FIG. 8

FIG. 5

FIG. 6

FIG. 7

EP 0 158 035 B1